# EUROPÄISCHE PATENTANMELDUNG

(11) **EP 4 202 756 A1**
(43) Veröffentlichungstag der Anmeldung: **28.06.2023**
(21) Anmeldenummer: 22207367.8
(22) Anmeldetag: 15.11.2022
(51) Int. Cl.: G06F 30/20, G06F 11/34

(54) **VERFAHREN ZUM BESTIMMEN EINES RECHENAUFWANDS EINES VIRTUELLEN TESTS, TRAININGSVERFAHREN UND TESTEINHEIT**

(30) Priorität: 06.12.2021 DE 102021132007
(71) Anmelder: dSPACE GmbH, 33102 Paderborn (DE)
(72) Erfinder: Bouillon, Patrick, 33102 Paderborn (DE); Miller, Eduard, 33102 Paderborn (DE); Bannenberg, Sebastian, 33102 Paderborn (DE); Löffler, Renate, 33102 Paderborn (DE); Hölscher, Christian, 33098 Paderborn (DE)

(57) **Zusammenfassung**

Die Erfindung betrifft ein Verfahren und System (1) zum Bestimmen eines Rechenaufwands eines virtuellen Tests (10) einer Vorrichtung (12) zur zumindest teilweisen autonomen Führung eines Kraftfahrzeugs, mit einem Anwenden (S2) eines zweiten Algorithmus (A2) auf den zumindest einen Parametersatz (P1) von Fahrsituationsparametern (14) und die Konfigurationsdaten (16) des den virtuellen Test (10) durchführenden ersten Algorithmus (A1) zum Bestimmen des Rechenaufwands des durch den ersten Algorithmus (A1) durchgeführten virtuellen Tests (10) der Vorrichtung (12) zur zumindest teilweisen autonomen Führung des Kraftfahrzeugs. Die Erfindung betrifft des Weiteren ein Verfahren zum Bereitstellen eines Algorithmus maschinellen Lernens (A2) zum Bestimmen eines Rechenaufwands (R1, R2, R3) eines virtuellen Tests (10) einer Vorrichtung (12) zur zumindest teilweisen autonomen Führung eines Kraftfahrzeugs.

## Beschreibung

Die vorliegende Erfindung betrifft ein computerimplementiertes Verfahren zum Bestimmen eines Rechenaufwands eines virtuellen Tests einer Vorrichtung zur zumindest teilweisen autonomen Führung eines Kraftfahrzeugs.

Die vorliegende Erfindung betrifft des Weiteren ein computerimplementiertes Verfahren zum Bereitstellen eines Algorithmus maschinellen Lernens zum Bestimmen eines Rechenaufwands eines virtuellen Tests einer Vorrichtung zur zumindest teilweisen autonomen Führung eines Kraftfahrzeugs.

Darüber hinaus betrifft die Erfindung eine Testeinheit zum Bestimmen eines Rechenaufwands eines virtuellen Tests einer Vorrichtung zur zumindest teilweisen autonomen Führung eines Kraftfahrzeugs.

### Stand der Technik

Fahrassistenzsysteme wie z.B. ein adaptiver Geschwindigkeitsregler und/oder Funktionen für das hochautomatisierte Fahren können mithilfe diverser Überprüfungsmethoden verifiziert bzw. validiert werden. Dabei können insbesondere Simulationen verwendet werden.

Der Aufwand, insbesondere der Zeit- und/oder Kostenaufwand, zum Testen derartiger Fahrzeugfunktionen unter Verwendung von Simulationen ist dabei typischerweise hoch, da eine große Anzahl potenziell möglicher Fahrsituationen getestet werden muss. Die Ausführung eines Testfalls mit einem ITC (Intelligent Test Control) Algorithmus kann somit unter Umständen sehr lange dauern und viele Ressourcen benötigen.

Es ist jedoch häufig nötig abschätzen zu können, wie lange und wie teuer die Ausführung wird. Zum Beispiel, um die Testausführung einplanen zu können oder um zu ermitteln, wie viele Rechenknoten zur Verfügung gestellt werden müssen.

Der Einsatz von ITC verschärft das Problem, da bei der Testdefinition noch nicht berechnet werden kann, wie viele Simulationen gefahren werden müssen. Dies wird dynamisch vom ITC-Algorithmus berechnet, abhängig von den Ergebnissen der einzelnen Durchläufe. Zusammenfassend ist die Abschätzung also vom ITC-Algorithmus, der Ausführungsdauer der einzelnen Simulationen und der Anzahl der verwendeten Knoten abhängig.

Bisher kann das Problem derart umgangen werden, dass die Ausführung der Tests auf das notwendige Minimum beschränkt wird und die Mitarbeiter engmaschig kontrolliert werden (z.B. nur über Freigabeprozesse eine Simulation starten zu können). Alternativ können die anfallenden Kosten in Kauf genommen werden.

Demzufolge besteht ein Bedarf, bestehende Testverfahren für Fahrassistenzsysteme dahingehend zu verbessern, dass ein Bestimmen eines Rechenaufwands einer Simulation eines Testfalls ermöglicht wird.

Es ist daher Aufgabe der Erfindung, ein Verfahren zum Bestimmen eines Rechenaufwands eines virtuellen Tests einer Vorrichtung zur zumindest teilweisen autonomen Führung eines Kraftfahrzeugs bereitzustellen.

### Offenbarung der Erfindung

Die Aufgabe wird erfindungsgemäß durch ein computerimplementiertes Verfahren zum Bestimmen eines Rechenaufwands eines virtuellen Tests einer Vorrichtung zur zumindest teilweisen autonomen Führung eines Kraftfahrzeugs mit den Merkmalen des Patentanspruchs 1 gelöst.

Die Aufgabe wird erfindungsgemäß des Weiteren durch ein computerimplementiertes Verfahren zum Bereitstellen eines Algorithmus maschinellen Lernens zum Bestimmen eines Rechenaufwands eines virtuellen Tests einer Vorrichtung zur zumindest teilweisen autonomen Führung eines Kraftfahrzeugs mit den Merkmalen des Patentanspruchs 13 gelöst.

Die Aufgabe wird erfindungsgemäß ferner durch eine Testeinheit zum Bestimmen eines Rechenaufwands eines virtuellen Tests einer Vorrichtung zur zumindest teilweisen autonomen Führung eines Kraftfahrzeugs mit den Merkmalen des Patentanspruchs 14 gelöst.

Die Erfindung betrifft ein computerimplementiertes Verfahren zum Bestimmen eines Rechenaufwands eines virtuellen Tests einer Vorrichtung zur zumindest teilweisen autonomen Führung eines Kraftfahrzeugs.

Das Verfahren umfasst ein Bereitstellen zumindest eines Parametersatzes von Fahrsituationsparametern und von Konfigurationsdaten eines den virtuellen Test durchführenden ersten Algorithmus, wobei der durch den ersten Algorithmus durchgeführte virtuelle Test den zumindest einen Parametersatz von Fahrsituationsparametern simuliert, und wobei das Ergebnis der Simulation zum Bestimmen zumindest eines, in einer darauffolgenden Iteration simulierten weiteren Parametersatzes von Fahrsituationsparametern verwendet wird.

Des Weiteren umfasst das Verfahren ein Anwenden eines zweiten Algorithmus auf den zumindest einen Parametersatz von Fahrsituationsparametern und die Konfigurationsdaten des den virtuellen Test durchführenden ersten Algorithmus zum Bestimmen des Rechenaufwands des durch den ersten Algorithmus durchgeführten virtuellen Tests der Vorrichtung zur zumindest teilweisen autonomen Führung des Kraftfahrzeugs und ein Ausgeben zumindest eines den Rechenaufwand des virtuellen Tests repräsentierenden numerischen Wertes.

Die Erfindung betrifft ferner ein computerimplementiertes Verfahren zum Bereitstellen eines Algorithmus maschinellen Lernens zum Bestimmen eines Rechenaufwands eines virtuellen Tests einer Vorrichtung zur zumindest teilweisen autonomen Führung eines Kraftfahrzeugs.

Das Verfahren umfasst ein Bereitstellen eines ersten Trainingsdatensatzes von Fahrsituationsparametern und von Konfigurationsdaten eines den virtuellen Test durchführenden ersten Algorithmus sowie ein Bereitstellen eines zweiten Trainingsdatensatzes von, einen Rechenaufwand des virtuellen Tests repräsentierenden numerischen Werten.

Darüber hinaus umfasst das Verfahren ein Trainieren des Algorithmus maschinellen Lernens unter Verwendung der Fahrsituationsparameter und der Konfigurationsdaten des den virtuellen Test durchführenden ersten Algorithmus und der, den Rechenaufwand des virtuellen Tests repräsentierenden numerischen Werte durch einen Optimierungsalgorithmus, welcher einen Extremwert einer Verlustfunktion berechnet.

Testeinheit zum Bestimmen eines Rechenaufwands eines virtuellen Tests einer Vorrichtung zur zumindest teilweisen autonomen Führung eines Kraftfahrzeugs.

Die Testeinheit umfasst Mittel zum Bereitstellen zumindest eines Parametersatzes von Fahrsituationsparametern und von Konfigurationsdaten eines den virtuellen Test durchführenden ersten Algorithmus, wobei der durch den ersten Algorithmus durchgeführte virtuelle Test den zumindest einen Parametersatz von Fahrsituationsparametern simuliert, und wobei das Ergebnis der Simulation zum Bestimmen zumindest eines, in einer darauffolgenden Iteration simulierten weiteren Parametersatz von Fahrsituationsparametern verwendbar ist.

Die Testeinheit umfasst ferner ein Steuergerät, welches dazu eingerichtet ist, den zweiten Algorithmus auf den zumindest einen Parametersatz von Fahrsituationsparametern und die Konfigurationsdaten des den virtuellen Test durchführenden ersten Algorithmus zum Bestimmen des Rechenaufwands des durch den ersten Algorithmus durchgeführten virtuellen Tests der Vorrichtung zur zumindest teilweisen autonomen Führung des Kraftfahrzeugs anzuwenden, und wobei das Steuergerät dazu eingerichtet ist, zumindest einen den Rechenaufwand des virtuellen Tests repräsentierenden numerischen Wert auszugeben.

Die Erfindung betrifft ferner ein Computerprogramm mit Programmcode, um das erfindungsgemäße Verfahren durchzuführen, wenn das Computerprogramm auf einem Computer ausgeführt wird.

Eine Idee der vorliegenden Erfindung ist es, eine Vorabschätzung eines Rechenaufwands eines virtuellen Tests einer Vorrichtung zur zumindest teilweisen autonomen Führung eines Kraftfahrzeugs zu bieten.

Durch das Anwenden des zweiten Algorithmus auf den zumindest einen Parametersatz von Fahrsituationsparametern und die Konfigurationsdaten des den virtuellen Test durchführenden ersten Algorithmus zum Bestimmen des Rechenaufwands des durch den ersten Algorithmus durchgeführten virtuellen Tests der Vorrichtung zur zumindest teilweisen autonomen Führung des Kraftfahrzeugs kann in vorteilhafter Weise unter Verwendung von Informationen aus dem Szenario, z.B. wie lange eine Simulation im erfolgreichen Fall läuft, der Rechenaufwand bestimmt werden.

Weitere Ausführungsformen der vorliegenden Erfindung sind Gegenstand der weiteren Unteransprüche und der nachfolgenden Beschreibung unter Bezugnahme auf die Figuren.

Gemäß einer bevorzugten Weiterbildung der Erfindung ist vorgesehen, dass der zumindest eine Parametersatz von Fahrsituationsparametern zumindest einen die Umgebung des Kraftfahrzeugs beschreibenden Umgebungsparameter und zumindest einen den Zustand des Kraftfahrzeugs beschreibenden Egoparameter aufweist. Der dadurch erzeugte Zustandsraum kann somit eine Vielzahl möglicher Testfälle abbilden.

Gemäß einer weiteren bevorzugten Weiterbildung der Erfindung ist vorgesehen, dass die Konfigurationsdaten des den virtuellen Test durchführenden ersten Algorithmus zu testende Wertebereiche der Fahrsituationsparameter, eine, insbesondere vorgegebene oder durch den ersten Algorithmus parametrierbare, Schrittweite der zu testenden Fahrsituationsparameter und/oder eine Anzahl von Simulationen pro Iteration umfassen. Dadurch können beispielsweise eine mögliche Anzahl von Parametervariationen eines Testfalls sowie ein Rechenaufwand einer jeweiligen Iteration bestimmt werden.

Gemäß einer weiteren bevorzugten Weiterbildung der Erfindung ist vorgesehen, dass der zweite Algorithmus einen, einen minimalen Rechenaufwand des virtuellen Tests repräsentierenden, ersten numerischen Wert und einen, einen maximalen Rechenaufwand des virtuellen Tests repräsentierenden, zweiten numerischen Wert ausgibt.

Die Erfindung bietet somit eine Vorabschätzung. Diese beinhaltet eine Worst- und Best-Case Abschätzung der auszuführenden Simulationen basierend auf einer Historie.

Gemäß einer weiteren bevorzugten Weiterbildung der Erfindung ist vorgesehen, dass das Bestimmen des Rechenaufwands des virtuellen Tests durch den zweiten Algorithmus ein Berechnen eines durchschnittlichen Rechenaufwands umfasst, wobei der zweite Algorithmus einen, den durchschnittlichen Rechenaufwand repräsentierenden, dritten numerischen Wert ausgibt.

Anhand dieser Vorabschätzung kann der Nutzer die Simulationen besser einplanen. Durch die Auswahl einzusetzender Rechenknoten kann man sich so berechnen lassen, wann die Testausführung beendet wird und welche Kosten dadurch entstehen.

Gemäß einer weiteren bevorzugten Weiterbildung der Erfindung ist vorgesehen, dass die Ergebnisse jeder Simulation, insbesondere eine Dauer und/oder der Rechenaufwand jeder Simulation, in einer Datenbank gespeichert werden, und wobei das Bestimmen des durchschnittlichen Rechenaufwands unter Verwendung der gespeicherten Simulationsergebnisse durchgeführt wird.

In einer ITC-Datenbank werden daher Informationen über vorherige Durchläufe gespeichert, z.B. eine Anzahl von Simulationen pro Iteration und/oder eine Anzahl von Iterationen. Dadurch werden die Abschätzungen genauer.

Gemäß einer weiteren bevorzugten Weiterbildung der Erfindung ist vorgesehen, dass der durch den zweiten Algorithmus bestimmte Rechenaufwand des virtuellen Tests zur Laufzeit des ersten Algorithmus unter Verwendung des in der Datenbank gespeicherten durchschnittlichen Rechenaufwands, insbesondere vorhergehender Iterationen des virtuellen Tests, aktualisiert wird.

Der Anwender erhält dadurch während der Laufzeit des ersten Algorithmus eine kontinuierliche Aktualisierung eines voraussichtlichen Rechenaufwands des durchgeführten Testfalls.

Gemäß einer weiteren bevorzugten Weiterbildung der Erfindung ist vorgesehen, dass in der Datenbank weiter eine Anzahl von Simulationen pro Iteration, eine Anzahl von Iterationen, eine Bezeichnung einer Art des ersten Algorithmus, eine Bezeichnung der Fahrsituationsparameter und/oder ein zu testender Wertebereich der Fahrsituationsparameter gespeichert ist.

Dadurch kann eine genauere Vorabberechnung von den Testalgorithmus betreffen Parametern erfolgen, welche sodann bei der Bestimmung des voraussichtlichen Rechenaufwands des Testfalls verwendet werden.

Gemäß einer weiteren bevorzugten Weiterbildung der Erfindung ist vorgesehen, dass der zweite Algorithmus eine erste Rechenaufwandsbestimmung unter Verwendung des zumindest einen Parametersatzes von Fahrsituationsparametern und eine zweite Rechenaufwandsbestimmung unter Verwendung der Konfigurationsdaten des den virtuellen Test durchführenden ersten Algorithmus durchführt, wobei der zumindest eine den Rechenaufwand des virtuellen Tests repräsentierende numerische Wert unter Verwendung eines Ergebnisses der ersten Rechenaufwandsbestimmung und eines Ergebnisses der zweiten Rechenaufwandsbestimmung berechnet wird.

Die Kombination der Rechenaufwandsbestimmung unter Verwendung der Fahrsituationsparameter und der Konfigurationsdaten kann somit in vorteilhafter Weise eine genauere Bestimmung des voraussichtlichen Rechenaufwands ermöglichen.

Gemäß einer weiteren bevorzugten Weiterbildung der Erfindung ist vorgesehen, dass ein numerischer Wert einer Anzahl von für eine Durchführung des virtuellen Tests verwendeter Rechenknoten bereitgestellt wird, wobei der durch den zweiten Algorithmus ausgegebene, den Rechenaufwand des virtuellen Tests repräsentierende, numerische Wert sich auf die bereitgestellte Anzahl verwendeter Rechenknoten bezieht.

So können über die Vorabberechnung des voraussichtlichen Rechenaufwands des Testfalls zusammen mit der Anzahl der Knoten und der Kosten pro Knoten voraussichtlich resultierende Kosten aktualisiert und dem Nutzer zurückgemeldet werden.

Gemäß einer weiteren bevorzugten Weiterbildung der Erfindung ist vorgesehen, dass ein Kriterium zum Abbruch des durch den ersten Algorithmus durchgeführten virtuellen Tests der Vorrichtung zur zumindest teilweisen autonomen Führung eines Kraftfahrzeugs bereitgestellt wird, wobei das Kriterium bei Erreichen eines vorgegebenen Rechenaufwands erfüllt ist.

Sollte ein erforderlicher Rechenaufwand das vorab festgelegte Abbruchkriterium übersteigen, hat der Nutzer somit die Möglichkeit, die Berechnung abzubrechen oder unter Verwendung einer neuen Schätzung eines voraussichtlich verbleibenden Rechenaufwands die Berechnung fortzusetzen.

Gemäß einer weiteren bevorzugten Weiterbildung der Erfindung ist vorgesehen, dass der erste Algorithmus initiale Werte der Fahrsituationsparameter selektiert und in darauffolgenden Iterationen unter Verwendung von Simulationsergebnissen anpasst.

Über die Zeit sammelt der ITC-Algorithmus so für ein Szenario statistische Informationen und speichert diese am Szenario ab. Je mehr Durchläufe erfolgen, desto akkurater werden dadurch die geschätzten Worst- und Best-Case-Zeiten.

Die hierin beschriebenen Merkmale des Verfahrens zum Bestimmen eines Rechenaufwands eines virtuellen Tests einer Vorrichtung zur zumindest teilweisen autonomen Führung eines Kraftfahrzeugs sind ebenso auf die erfindungsgemäße Testeinheit zum Bestimmen eines Rechenaufwands eines virtuellen Tests einer Vorrichtung zur zumindest teilweisen autonomen Führung eines Kraftfahrzeugs und umgekehrt anwendbar.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen.

Nachfolgend wird die Erfindung anhand exemplarischer Ausführungsformen näher erläutert, die in den schematischen Abbildungen der Zeichnungen angegeben sind.

Es zeigen:
- Fig. 1: ein Ablaufdiagramm eines Verfahrens und einer Testeinheit zum Bestimmen eines Rechenaufwands eines virtuellen Tests einer Vorrichtung zur zumindest teilweisen autonomen Führung eines Kraftfahrzeugs gemäß einer bevorzugten Ausführungsform der Erfindung; und
- Fig.2: ein Ablaufdiagramm eines Verfahrens zum Bereitstellen eines Algorithmus maschinellen Lernens zum Bestimmen eines Rechenaufwands eines virtuellen Tests einer Vorrichtung zur zumindest teilweisen autonomen Führung eines Kraftfahrzeugs.

Sofern nicht anders angegeben, bezeichnen gleiche Bezugszeichen gleiche Elemente der Zeichnungen.

### Ausführliche Beschreibung der Ausführungsformen

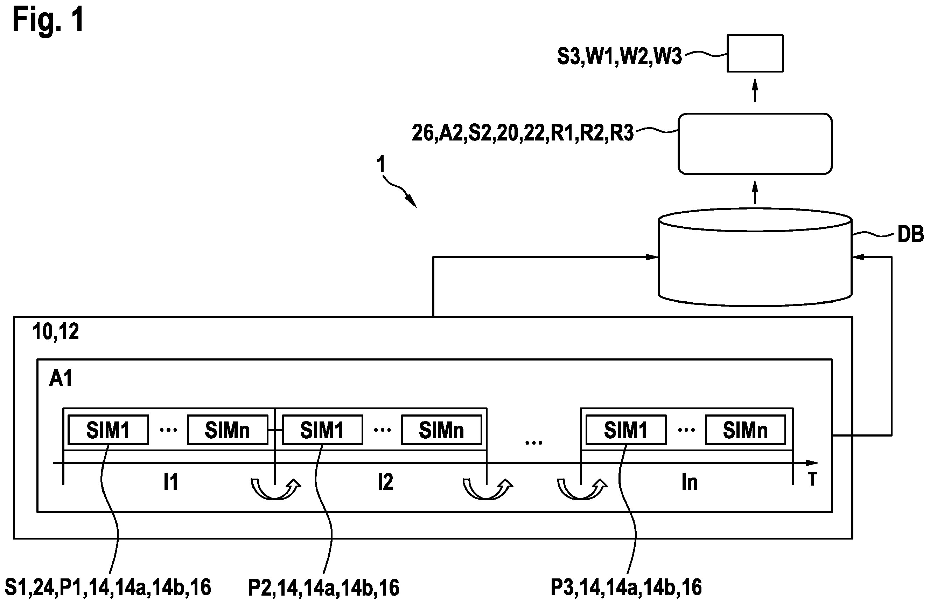

Das in Fig. 1 gezeigte Verfahren zum Bestimmen eines Rechenaufwands eines virtuellen Tests 10 einer Vorrichtung 12 zur zumindest teilweisen autonomen Führung eines Kraftfahrzeugs umfasst ein Bereitstellen S1 zumindest eines Parametersatzes P1 von Fahrsituationsparametern 14 und von Konfigurationsdaten 16 eines den virtuellen Test 10 durchführenden ersten Algorithmus A1, wobei der durch den ersten Algorithmus A1 durchgeführte virtuelle Test 10 zumindest einen Parametersatz P1 von Fahrsituationsparametern 14 simuliert, und wobei das Ergebnis der Simulation zum Bestimmen zumindest eines, in einer darauffolgenden Iteration I2-In simulierten weiteren Parametersatzes P2, P3 von Fahrsituationsparametern 14 verwendet wird.

Der zumindest eine Parametersatz P1 von Fahrsituationsparametern 14 weist zumindest einen die Umgebung des Kraftfahrzeugs beschreibenden Umgebungsparameter 14a und zumindest einen den Zustand des Kraftfahrzeugs beschreibenden Egoparameter 14b auf.

Der erste Algorithmus A1 selektiert initiale Werte der Fahrsituationsparameter 14 und passt diese in darauffolgenden Iterationen I2-In unter Verwendung von Simulationsergebnissen an.

Ferner umfasst das Verfahren ein Anwenden S2 eines zweiten Algorithmus A2 auf den zumindest einen Parametersatz P1 von Fahrsituationsparametern 14 und die Konfigurationsdaten 16 des den virtuellen Test 10 durchführenden ersten Algorithmus A1 zum Bestimmen des Rechenaufwands des durch den ersten Algorithmus A1 durchgeführten virtuellen Tests 10 der Vorrichtung 12 zur zumindest teilweisen autonomen Führung des Kraftfahrzeugs und ein Ausgeben S3 zumindest eines den Rechenaufwand des virtuellen Tests 10 repräsentierenden numerischen Wertes W1, W2, W3.

Die Konfigurationsdaten 16 des den virtuellen Test 10 durchführenden ersten Algorithmus A1 umfassen zu testende Wertebereiche der Fahrsituationsparameter 14, insbesondere eine vorgegebene oder durch den ersten Algorithmus A1 parametrierbare, Schrittweite der zu testenden Fahrsituationsparameter 14 und/oder eine Anzahl von Simulationen SIM1-SIMn pro Iteration I1-In.

Der zweite Algorithmus A2 gibt einen, einen minimalen Rechenaufwand R1 des virtuellen Tests 10 repräsentierenden, ersten numerischen Wert W1 und einen, einen maximalen Rechenaufwand R2 des virtuellen Tests 10 repräsentierenden, zweiten numerischen Wert W2 aus.

Das Bestimmen des Rechenaufwands R1, R2 des virtuellen Tests 10 durch den zweiten Algorithmus A2 umfasst ein Berechnen eines durchschnittlichen Rechenaufwands R3, wobei der zweite Algorithmus A2 einen, den durchschnittlichen Rechenaufwand R3 repräsentierenden, dritten numerischen Wert W3 ausgibt.

Die Ergebnisse jeder Simulation SIM1-SIMn, insbesondere eine Dauer T und/oder der Rechenaufwand R1, R2, R3 jeder Simulation SIM1-SIMn, werden in einer Datenbank DB gespeichert. Das Bestimmen des durchschnittlichen Rechenaufwands R3 wird dabei unter Verwendung der gespeicherten Simulationsergebnisse durchgeführt.

Der durch den zweiten Algorithmus A2 bestimmte Rechenaufwand R1, R2, R3 des virtuellen Tests 10 wird zur Laufzeit des ersten Algorithmus A1 unter Verwendung des in der Datenbank DB gespeicherten durchschnittlichen Rechenaufwands R3, insbesondere vorhergehender Iterationen I1-In des virtuellen Tests 10, aktualisiert.

In der Datenbank DB ist weiter eine Anzahl von Simulationen SIM1-SIMn pro Iteration I1-In, eine Anzahl von Iterationen I1-In, eine Bezeichnung einer Art des ersten Algorithmus A1, eine Bezeichnung der Fahrsituationsparameter 14 und/oder ein zu testender Wertebereich der Fahrsituationsparameter 14 gespeichert.

Der zweite Algorithmus A2 führt eine erste Rechenaufwandsbestimmung 20 unter Verwendung des zumindest einen Parametersatzes P1 von Fahrsituationsparametern 14 und eine zweite Rechenaufwandsbestimmung 22 unter Verwendung der Konfigurationsdaten 16 des den virtuellen Test 10 durchführenden ersten Algorithmus A1 durch.

Der zumindest eine den Rechenaufwand R1, R2, R3 des virtuellen Tests 10 repräsentierende numerische Wert W1, W2, W3 wird dabei unter Verwendung eines Ergebnisses der ersten Rechenaufwandsbestimmung 20 und eines Ergebnisses der zweiten Rechenaufwandsbestimmung 22 berechnet.

Ferner wird der numerische Wert W1, W2, W3 einer Anzahl von für eine Durchführung des virtuellen Tests 10 verwendeter Rechenknoten bereitgestellt. Der durch den zweiten Algorithmus A2 ausgegebene, den Rechenaufwand R1, R2, R3 des virtuellen Tests 10 repräsentierende, numerische Wert W1, W2, W3 bezieht sich auf die bereitgestellte Anzahl verwendeter Rechenknoten.

Darüber hinaus wird ein Kriterium zum Abbruch des durch den ersten Algorithmus A1 durchgeführten virtuellen Tests 10 der Vorrichtung 12 zur zumindest teilweisen autonomen Führung eines Kraftfahrzeugs bereitgestellt. Das Kriterium ist bei Erreichen eines vorgegebenen Rechenaufwands R1, R2, R3 erfüllt.

Die Testeinheit 1 umfasst Mittel 24 zum Bereitstellen zumindest eines Parametersatzes P1 von Fahrsituationsparametern 14 und von Konfigurationsdaten 16 eines den virtuellen Test 10 durchführenden ersten Algorithmus A1, wobei der durch den ersten Algorithmus A1 durchgeführte virtuelle Test 10 den zumindest einen Parametersatz P1 von Fahrsituationsparametern 14 simuliert, und wobei das Ergebnis der Simulation SIM1-SIMn zum Bestimmen zumindest eines, in einer darauffolgenden Iteration I2-In simulierten weiteren Parametersatzes P2, P3 von Fahrsituationsparametern 14 verwendbar ist.

Die Testeinheit 1 umfasst ferner ein Steuergerät 26, welches dazu eingerichtet ist, den zweiten Algorithmus A2 auf den zumindest einen Parametersatz P1 von Fahrsituationsparametern 14 und die Konfigurationsdaten 16 des den virtuellen Test 10 durchführenden ersten Algorithmus A1 zum Bestimmen des Rechenaufwands R1, R2, R3 des durch den ersten Algorithmus A1 durchgeführten virtuellen Tests 10 der Vorrichtung 12 zur zumindest teilweisen autonomen Führung des Kraftfahrzeugs anzuwenden, und wobei das Steuergerät 26 dazu eingerichtet ist, zumindest einen den Rechenaufwand R1, R2, R3 des virtuellen Tests 10 repräsentierenden numerischen Wert W1, W2, W3 auszugeben.

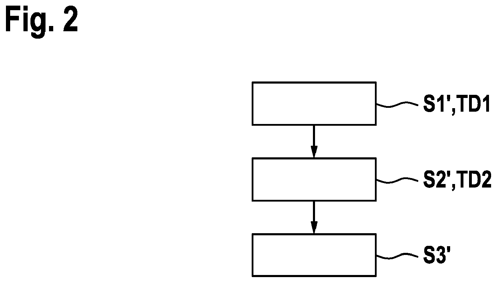

Fig.2 zeigt ein Ablaufdiagramm eines Verfahrens zum Bereitstellen eines Algorithmus maschinellen Lernens zum Bestimmen eines Rechenaufwands eines virtuellen Tests einer Vorrichtung zur zumindest teilweisen autonomen Führung eines Kraftfahrzeugs.

Das Verfahren umfasst ein Bereitstellen S1' eines ersten Trainingsdatensatzes TD1 von Fahrsituationsparametern 14 und von Konfigurationsdaten 16 eines den virtuellen Test 10 durchführenden ersten Algorithmus A1.

Das Verfahren umfasst ferner ein Bereitstellen S2' eines zweiten Trainingsdatensatzes TD2 von, einen Rechenaufwand R1, R2, R3 des virtuellen Tests 10 repräsentierenden numerischen Werten W1, W2, W3.

Darüber hinaus umfasst das Verfahren ein Trainieren S3' des Algorithmus maschinellen Lernens A2 unter Verwendung der Fahrsituationsparameter 14 und der Konfigurationsdaten 16 des den virtuellen Test 10 durchführenden ersten Algorithmus A1 und der, den Rechenaufwand R1, R2, R3 des virtuellen Tests 10 repräsentierenden numerischen Werte W1, W2, W3 durch einen Optimierungsalgorithmus, welcher einen Extremwert einer Verlustfunktion berechnet.

### Bezugszeichenliste

- 1: Testeinheit
- 10: virtueller Test
- 12: Vorrichtung
- 14: Fahrsituationsparameter
- 14a: Umgebungsparameter
- 14b: Egoparameter
- 16: Konfigurationsdaten
- 20: erste Rechenaufwandsbestimmung
- 22: zweite Rechenaufwandsbestimmung
- 24: Mittel
- 26: Steuergerät
- A1: erster Algorithmus
- A2: zweiter Algorithmus
- DB: Datenbank
- I1-In: Iteration
- P1: Parametersatz
- P2, P3: weitere Parametersätze
- R1, R2, R3: Rechenaufwand
- S1-S3: Verfahrensschritte
- S1'-S3': Verfahrensschritte
- SIM1-SIMn: Simulationen
- T: Zeit
- TD1: erster Trainingsdatensatz
- TD2: zweiter Trainingsdatensatz
- W1, W2, W3: numerischer Wert

## Patentansprüche

1. Computerimplementiertes Verfahren zum Bestimmen eines Rechenaufwands eines virtuellen Tests (10) einer Vorrichtung (12) zur zumindest teilweisen autonomen Führung eines Kraftfahrzeugs, mit den Schritten:
Bereitstellen (S1) zumindest eines Parametersatzes (P1) von Fahrsituationsparametern (14) und von Konfigurationsdaten (16) eines den virtuellen Test (10) durchführenden ersten Algorithmus (A1), wobei der durch den ersten Algorithmus (A1) durchgeführte virtuelle Test (10) den zumindest einen Parametersatz (P1) von Fahrsituationsparametern (14) simuliert, und wobei das Ergebnis der Simulation zum Bestimmen zumindest eines, in einer darauffolgenden Iteration (I2-In) simulierten weiteren Parametersatzes (P2, P3) von Fahrsituationsparametern (14) verwendet wird;
Anwenden (S2) eines zweiten Algorithmus (A2) auf den zumindest einen Parametersatz (P1) von Fahrsituationsparametern (14) und die Konfigurationsdaten (16) des den virtuellen Test (10) durchführenden ersten Algorithmus (A1) zum Bestimmen des Rechenaufwands des durch den ersten Algorithmus (A1) durchgeführten virtuellen Tests (10) der Vorrichtung (12) zur zumindest teilweisen autonomen Führung des Kraftfahrzeugs; und
Ausgeben (S3) zumindest eines den Rechenaufwand des virtuellen Tests (10) repräsentierenden numerischen Wertes (W1, W2, W3).

2. Computerimplementiertes Verfahren nach Anspruch 1, wobei der zumindest eine Parametersatz (P1) von Fahrsituationsparametern (14) zumindest einen die Umgebung des Kraftfahrzeugs beschreibenden Umgebungsparameter (14a) und zumindest einen den Zustand des Kraftfahrzeugs beschreibenden Egoparameter (14b) aufweist.

3. Computerimplementiertes Verfahren nach Anspruch 1 oder 2, wobei die Konfigurationsdaten (16) des den virtuellen Test (10) durchführenden ersten Algorithmus (A1) zu testende Wertebereiche der Fahrsituationsparameter (14), eine, insbesondere vorgegebene oder durch den ersten Algorithmus (A1) parametrierbare, Schrittweite der zu testenden Fahrsituationsparameter (14) und/oder eine Anzahl von Simulationen (SIM1-SIMn) pro Iteration (I1-In) umfassen.

4. Computerimplementiertes Verfahren nach einem der vorhergehenden Ansprüche, wobei der zweite Algorithmus (A2) einen, einen minimalen Rechenaufwand (R1) des virtuellen Tests (10) repräsentierenden, ersten numerischen Wert (W1) und einen, einen maximalen Rechenaufwand (R2) des virtuellen Tests (10) repräsentierenden, zweiten numerischen Wert (W2) ausgibt.

5. Computerimplementiertes Verfahren nach Anspruch 4, wobei das Bestimmen des Rechenaufwands (R1, R2) des virtuellen Tests (10) durch den zweiten Algorithmus (A2) ein Berechnen eines durchschnittlichen Rechenaufwands (R3) umfasst, wobei der zweite Algorithmus (A2) einen, den durchschnittlichen Rechenaufwand (R3) repräsentierenden, dritten numerischen Wert (W3) ausgibt.

6. Computerimplementiertes Verfahren nach Anspruch 5, wobei die Ergebnisse jeder Simulation (SIM1-SIMn), insbesondere eine Dauer und/oder der Rechenaufwand (R1, R2, R3) jeder Simulation (SIM1-SIMn), in einer Datenbank (DB) gespeichert werden, und wobei das Bestimmen des durchschnittlichen Rechenaufwands (R3) unter Verwendung der gespeicherten Simulationsergebnisse durchgeführt wird.

7. Computerimplementiertes Verfahren nach Anspruch 5 oder 6, wobei der durch den zweiten Algorithmus (A2) bestimmte Rechenaufwand (R1, R2, R3) des virtuellen Tests (10) zur Laufzeit des ersten Algorithmus (A1) unter Verwendung des in der Datenbank (DB) gespeicherten durchschnittlichen Rechenaufwands (R3), insbesondere vorhergehender Iterationen (I1-In) des virtuellen Tests (10), aktualisiert wird.

8. Computerimplementiertes Verfahren nach Anspruch 6 oder 7, wobei in der Datenbank (DB) weiter eine Anzahl von Simulationen (SIM1-SIMn) pro Iteration (I1-In), eine Anzahl von Iterationen (I1-In), eine Bezeichnung einer Art des ersten Algorithmus (A1), eine Bezeichnung der Fahrsituationsparameter (14) und/oder ein zu testender Wertebereich der Fahrsituationsparameter (14) gespeichert ist.

9. Computerimplementiertes Verfahren nach einem der vorhergehenden Ansprüche, wobei der zweite Algorithmus (A2) eine erste Rechenaufwandsbestimmung (20) unter Verwendung des zumindest einen Parametersatzes (P1) von Fahrsituationsparametern (14) und eine zweite Rechenaufwandsbestimmung (22) unter Verwendung der Konfigurationsdaten (16) des den virtuellen Test (10) durchführenden ersten Algorithmus (A1) durchführt, wobei der zumindest eine den Rechenaufwand (R1, R2, R3) des virtuellen Tests (10) repräsentierende numerische Wert (W1, W2, W3) unter Verwendung eines Ergebnisses der ersten Rechenaufwandsbestimmung (20) und eines Ergebnisses der zweiten Rechenaufwandsbestimmung (22) berechnet wird.

10. Computerimplementiertes Verfahren nach einem der vorhergehenden Ansprüche, wobei ein numerischer Wert (W1, W2, W3) einer Anzahl von für eine Durchführung des virtuellen Tests (10) verwendeter Rechenknoten bereitgestellt wird, wobei der durch den zweiten Algorithmus (A2) ausgegebene, den Rechenaufwand (R1, R2, R3) des virtuellen Tests (10) repräsentierende, numerische Wert (W1, W2, W3) sich auf die bereitgestellte Anzahl verwendeter Rechenknoten bezieht.

11. Computerimplementiertes Verfahren nach einem der vorhergehenden Ansprüche, wobei ein Kriterium zum Abbruch des durch den ersten Algorithmus (A1) durchgeführten virtuellen Tests (10) der Vorrichtung (12) zur zumindest teilweisen autonomen Führung eines Kraftfahrzeugs bereitgestellt wird, wobei das Kriterium bei Erreichen eines vorgegebenen Rechenaufwands (R1, R2, R3) erfüllt ist.

12. Computerimplementiertes Verfahren nach einem der vorhergehenden Ansprüche, wobei der erste Algorithmus (P1) initiale Werte der Fahrsituationsparameter (14) selektiert und in darauffolgenden Iterationen (I2-In) unter Verwendung von Simulationsergebnissen anpasst.

13. Computerimplementiertes Verfahren zum Bereitstellen eines Algorithmus maschinellen Lernens (A2) zum Bestimmen eines Rechenaufwands (R1, R2, R3) eines virtuellen Tests (10) einer Vorrichtung (12) zur zumindest teilweisen autonomen Führung eines Kraftfahrzeugs, mit den Schritten:
Bereitstellen (S1') eines ersten Trainingsdatensatzes (TD1) von Fahrsituationsparametern (14) und von Konfigurationsdaten (16) eines den virtuellen Test (10) durchführenden ersten Algorithmus (A1);
Bereitstellen (S2') eines zweiten Trainingsdatensatzes (TD2) von, einen Rechenaufwand (R1, R2, R3) des virtuellen Tests (10) repräsentierenden numerischen Werten (W1, W2, W3); und
Trainieren (S3') des Algorithmus maschinellen Lernens (A2) unter Verwendung der Fahrsituationsparameter (14) und der Konfigurationsdaten (16) des den virtuellen Test (10) durchführenden ersten Algorithmus (A1) und der, den Rechenaufwand (R1, R2, R3) des virtuellen Tests (10) repräsentierenden numerischen Werte (W1, W2, W3) durch einen Optimierungsalgorithmus, welcher einen Extremwert einer Verlustfunktion berechnet.

14. Testeinheit (1) zum Bestimmen eines Rechenaufwands (R1, R2, R3) eines virtuellen Tests (10) einer Vorrichtung (12) zur zumindest teilweisen autonomen Führung eines Kraftfahrzeugs, umfassend:
Mittel (24) zum Bereitstellen zumindest eines Parametersatzes (P1) von Fahrsituationsparametern (14) und von Konfigurationsdaten (16) eines den virtuellen Test (10) durchführenden ersten Algorithmus (A1), wobei der durch den ersten Algorithmus (A1) durchgeführte virtuelle Test (10) des zumindest einen Parametersatzes (P1) von Fahrsituationsparametern (14) simuliert, und wobei das Ergebnis der Simulation (SIM1-SIMn) zum Bestimmen zumindest eines, in einer darauffolgenden Iteration (I2-In) simulierten weiteren Parametersatzes (P2, P3) von Fahrsituationsparametern (14) verwendbar ist; und ein Steuergerät (26), welches dazu eingerichtet ist, den zweiten Algorithmus (A2) auf den zumindest einen Parametersatz (P1) von Fahrsituationsparametern (14) und die Konfigurationsdaten (16) des den virtuellen Test (10) durchführenden ersten Algorithmus (A1) zum Bestimmen des Rechenaufwands (R1, R2, R3) des durch den ersten Algorithmus (A1) durchgeführten virtuellen Tests (10) der Vorrichtung (12) zur zumindest teilweisen autonomen Führung des Kraftfahrzeugs anzuwenden, und
wobei das Steuergerät (26) dazu eingerichtet ist, zumindest einen den Rechenaufwand (R1, R2, R3) des virtuellen Tests (10) repräsentierenden numerischen Wert (W1, W2, W3) auszugeben.

15. Computerprogramm mit Programmcode, um das Verfahren nach einem der Ansprüche 1 bis 12 durchzuführen, wenn das Computerprogramm auf einem Computer ausgeführt wird.
